# EUROPÄISCHE PATENTSCHRIFT

(11) **EP 0 513 410 B1**
(45) Veröffentlichungstag und Bekanntmachung des Hinweises auf die Patenterteilung: **15.12.1993**
(21) Anmeldenummer: 91107831.9
(22) Anmeldetag: 15.05.1991
(51) Int. Cl.: H01L 25/07, H01L 21/50

(54) **Leistungshalbleitermodul und Verfahren zur Herstellung eines solchen Moduls**
Semiconductor power module and method of making such a module
Module semi-conducteur de puissance et procédé de fabrication d'un tel module

(43) Veröffentlichungstag der Anmeldung: 19.11.1992
(73) Patentinhaber: IXYS Semiconductor GmbH, D-68623 Lampertheim (DE)
(72) Erfinder: Neidig, Arno, Dr., W-6831 Plankstadt (DE); Hettmann, Hubert, W-6832 Hockenheim (DE)
(74) Vertreter: Rupprecht, Klaus, Dipl.-Ing.

(56) Entgegenhaltungen:
- EP-A- 0 138 048
- EP-A- 0 237 739
- EP-A- 0 292 848
- FR-A- 2 535 898
- US-A- 4 630 174

## Beschreibung

Die Erfindung bezieht sich auf ein Leistungshalbleitermodul mit Kunststoffgehäuse und mit nach außen führenden elektrischen Anschlußelementen, sowie auf ein Verfahren zur Herstellung des Leistungshalbleitermoduls.

Leistungshalbleitermodule sind in der üblichen Anwendung in elektrischen Geräten oder Anlagen über externe Anschlußleitungen mit anderen Komponenten des Gerätes oder der Anlage verbunden. Die externen Anschlußleitungen können mit erheblichen Zug- und Druckkräften über die elektrischen Anschlußelemente des Moduls auf Lötanschlußflächen im Modulinneren wirken und dort Schäden herbeiführen. Um eine solche Krafteinwirkung auf die Lötanschlüsse zu verhindern, ist es Stand der Technik die äußeren Anschlüsse dadurch zu fixieren, daß in einem letzten Herstellungsschritt eine steif aushärtende Vergußmasse in das Gehäuse gefüllt wird. Dieser Prozeß erfolgt nach dem Verkleben des Gehäuses mit einer Grundplatte und nach dem Einfüllen einer relativ dünnen Schicht einer elastischen Weichvergußmasse auf Silikonbasis zum Schutz empfindlicher Verbindungsteile, wie z.B. Bonddrähte oder Halbleiterchips.

Aus der DE-OS 37 17 489 ist ein Leistungshalbleitermodul mit Kunststoffgehäuse bekannt, von dem die Erfindung ausgeht. Das daraus bekannte Leistungshalbleitermodul hat ein Kunststoffgehäuse mit Führungsschächten oder Ausnehmungen, die während der Modulherstellung als Lötform für Bauteile, auch für nach außen führende elektrische Anschlußelemente, wirken. Die in der DE-OS 37 17 489 vorgeschlagenen Maßnahmen entlasten jedoch nicht die Lötanschlußflächen im Modulinneren. Deshalb wird auch dieses bekannte Modul mit einer Hartvergußmasse, z.B. einem Epoxidharz ausgefüllt.

Das Vergießen mit einer aushärtenden Vergußmasse hat mehrere Nachteile:
a) Die Handhabung der meist zweikomponentigen, nämlich aus Harz und Härter bestehenden Epoxidharze in der Fertigung, ist nicht einfach. Epoxide dürfen in nichtausgehärtetem Zustand nicht mit der Haut in Berührung kommen. Die Vergußmassen müssen in der Regel heiß verarbeitet werden um die notwendige Fließfähigkeit zu erreichen. Anschließend muß die Vergußmasse bei etwa 130°C in einem Ofen mehrere Stunden ausgehärtet werden, bis die nötige Festigkeit erreicht ist. Hierzu sind Kammeröfen erforderlich. Wegen der langen Prozeßzeiten sind keine Durchlaufverfahren möglich; dies ist ein Nachteil, wenn hohe Stückzahlen zu fertigen sind.
b) Das Vergießen mit Epoxidharz ist ein relativ schmutziger Prozeß. Epoxidharze sind bedingt durch den Herstellungsprozeß unrein, d.h. sie enthalten Chlor- und Natriumionen. Die Ionen können auch nach dem Aushärten in der Vergußmasse unter dem Einfluß elektrischer Felder wandern und die elektrischen Kennlinien von Bauelementen verändern. Es werden zwar auch weitgehend gereinigte Vergußmassen angeboten, die jedoch entsprechend teuer sind. In der Regel werden noch Zusätze, wie Flammschutzmittel, Flexibilisatoren und mineralische Füllstoffe dem Harz beigemischt, um bestimmte Vorschriften zu erfüllen und um bessere mechanische Eigenschaften einzustellen. Durch die Füllstoffe wird es jedoch eher schwieriger die außerdem bestehenden Reinheitsanforderungen zu erfüllen.
c) Ein weiterer Nachteil der Vergießharze ist ihr beträchtlicher Schrumpf beim Aushärten und der hohe thermische Ausdehnungskoeffizient, der nur begrenzt durch mineralische Füllstoffe verringert werden kann. Beim Abkühlen von der Aushärtetemperatur herunter auf Raumtemperatur kommt es daher zu mechanischen Verspannungen, die sich negativ auf die Geometrie und die Stabilität des Kunststoffgehäuses auswirken können.
d) Werden im Modul beispielsweise zusätzliche Schaltungsebenen integriert, wie in der nicht vorveröffentlichten deutschen Patentanmeldung P 40 20 849.4 vorgeschlagen wird, dann ist die zusätzliche Hartvergußmasse störend. Denn die empfindlichen Bauteile der Platinen, z.B. in Oberflächenmontagetechnik, sollten nicht im Hartverguß eingebettet werden, da sie sonst wegen des Schrumpfes und wegen der hohen thermischen Dehnung des Hartvergusses von der Platine an den Lötverbindungen abgerissen werden könnten. Alternativ müßte man die Modulhöhe vergrößern, um noch im Weichvergußbereich für die zusätzliche Platine Platz zu schaffen. Ein höheres Modul erfordert jedoch nicht nur einen höheren Materialaufwand, sondern verbietet sich im allgemeinen auch wegen Überschreitung der für die jeweilige Gehäuseform genormten Bauhöhe.

Der Erfindung liegt daher die Aufgabe zugrunde, ein Leistungshalbleitermodul mit Kunststoffgehäuse und ein Verfahren zu seiner Herstellung anzugeben, bei dem unter Verzicht auf eine Hartvergußmasse die erforderliche Festigkeit der Anschlußelemente erzielt wird.

Diese Aufgabe wird durch ein Leistungshalbleitermodul mit wenigstens einem Leistungshalbleiterbauelement, Anschlußelementen für nach außen führende elektrische Anschlüsse und einem Kunststoffgehäuse, das im Inneren angeformte Führungselemente aus Kunststoff aufweist, die während der Modulherstellung als Lötform für die Anschlußelemente wirken, wobei die Anschlußelemente durch verformte Teile der Führungselemente mechanisch fest mit dem Kunststoffgehäuse verbunden sind.

Die Aufgabe wird außerdem durch ein Verfahren zur Herstellung eines solchen Leistungshalbleitermoduls gelöst, das weiter unten beschrieben und im Anspruch 5 angegeben ist.

Die mit der Erfindung vorgeschlagene Art der Befestigung von Anschlußelementen am Kunststoffgehäuse hat den Vorteil, daß außer der Entlastung der Lötanschlüsse auch erreicht wird, daß mechanische Schwingungen, die in Anschlußleitungen auftreten können, wirksam über das Kunststoffgehäuse gedämpft werden. Außerdem läßt sich die Modulherstellung z.B. durch Automatisierung rationell durchführen. Weitere Vorteile und vorteilhafte Ausgestaltungsmöglichkeiten ergeben sich aus der nachstehenden Beschreibung eines in der Zeichnung dargestellten Ausführungsbeispiels.

Es zeigen:
- Figur 1: ein erfindungsgemäßes Leistungshalbleitermodul in Explosionsdarstellung,
- Figur 2: ein mit Anschlußelementen bestücktes Modulgehäuse in Aufsicht,
- Figur 3: eine Anschlußlasche,
- Figur 4: einen Schnitt durch ein Modul vor Durchführung einer Ultraschall-Schweißung zur Befestigung einer Anschlußlasche,
- Figur 5: einen Schnitt durch ein Modul nach Durchführung der Ultraschall-Schweißung,
- Figur 6: einen Schnitt durch ein Kunststoffgehäuse mit eingesetzten Anschlußlaschen.

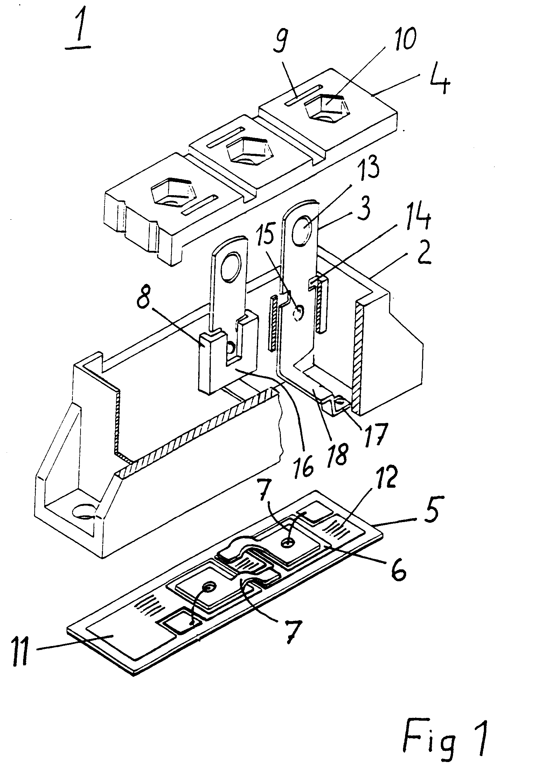

Figur 1 zeigt eine perspektivische Ansicht eines Leistungshalbleitermoduls 1 in Explosionsdarstellung. Es sind drei wesentliche Teile des Moduls 1 zu erkennen: Ein Kunststoffgehäuse 2 mit Anschlußlaschen 3, ein Gehäusedeckel 4 und ein Substrat 5 mit aufgelöteten Halbleiterbauelementen 6 und modulinternen Verbindungselementen 7. Die Laschen 3 stecken in Taschen oder Führungsschächten, die durch Führungselemente 8 im Inneren des Kunststoffgehäuses gebildet sind. Die Führungselemente 8 sind im dargestellten Beispiel zwei winkelförmige Anformungen an einer Innenwand im Modulgehäuse 2 mit einem Querbalken 16 zwischen den winkelförmigen Anformungen.

Ein Gehäusedeckel 4 ist nicht bei allen Modulvarianten erforderlich. Im dargestellten Beispiel ist jedoch ein Deckel 4 vorgesehen, der z.B. mittels Ultraschall-Schweißung mit dem Gehäuse 2 verbunden werden kann. Der Deckel 4 weist Schlitze 9 zur DUrchführung der Anschlußlaschen 3 auf, sowie Vertiefungen 10 zur Aufnahme von Sechskantmuttern. Nach dem Einlegen der Muttern werden die Anschlußlaschen 3 umgebogen, so daß Anschlußschrauben durch ein Loch 13 der Laschen 3 gesteckt und in die Muttern geschraubt werden können.

Das Substrat 5 kann z.B. ein Keramiksubstrat sein, das Leiterbahnen 11 trägt und auf dem die Halbleiterbauelemente 6 aufgelötet sind. Auf den Leiterbahnen 11 sind mit Lot benetzte Anschlußflächen 12 für die Verlötung mit Anschlußlaschen 3 vorbereitet. Die Unterseite des Keramiksubstrats kann mit einer Metallschicht versehen sein.

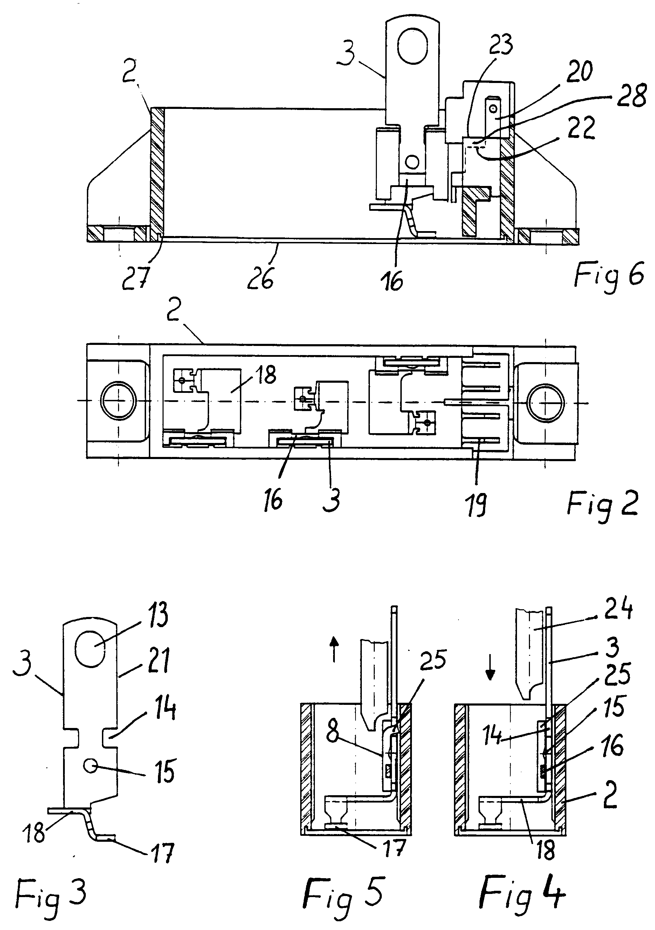

Figur 2 zeigt ähnlich wie Figur 1 ein Kunststoffgehäuse 2 mit Anschlußlaschen 3. In das in Aufsicht dargestellte Gehäuse 2 sind drei Anschlußlaschen 3 eingesteckt. Auf der rechten Seite sind vier schmale Ausnehmungen 19 zu erkennen, in die Steueranschlußteile 20 (siehe Figur 6) eingesteckt und mittels Ultraschall verdämmt werden können.

In Figur 6 ist ein Modul dargestellt, das dem in Figur 2 gezeigten Modul entspricht und wobei ein Steueranschlußteil 20 gezeigt ist, das eine Schulter 22 hat, die etwas tiefer liegt als die obere Kante 23 eines Kunststoffteils 28. Der über die Schulter 22 ragende Kunststoff kann mit Hilfe einer Sonotrode im Ultraschallschweißverfahren in die Ausnehmungen 19 gedrückt werden, um das Steueranschlußteil 20 im Gehäuse 2 zu befestigen. In Figur 6 ist im übrigen ein Gehäuse 2 mit einer großen Öffnung 26 und einem Absatz 27 in der Bodenebene des Gehäuses dargestellt, in die ein Substrat 5 einsetzbar ist.

Sowohl in Figur 1 als auch in Figur 3, die eine Anschlußlasche 3 zeigt, sind weitere Einzelheiten zur Ausführung der Anschlußlaschen 3 dargestellt, nämlich Einkerbungen 14 und eine Ausbeulung 15. Die Einkerbungen 14 sind zur Aufnahme von Kunststoff vorgesehen, wie weiter unten zu Figur 4 und 5 erläutert wird. Die Ausbeulung 15 wirkt mit dem Querbalken 16 der Führungselemente 8 am Kunststoffgehäuse 2 zusammen. Der Querbalken 16 ist nachgiebig und ermöglicht somit beim Einstecken der Anschlußlaschen 3 von unten her in die Führungselemente 8 ein Einschnappen. Die Ausbeulung 15 verhindert anschließend während der weiteren Fertigungsschritte ein Herausfallen der Anschlußlasche 3 aus dem Führungsschacht.

Weiterhin ist an der Anschlußlasche 3 im unteren Bereich ein Laschenfuß 17 zu erkennen, der zur Verlötung mit den Anschlußflächen 12 auf dem Substrat 5 vorgesehen ist. Darauf folgt ein etwa parallel zur Substratebene verlaufendes Laschenstück 18, das kleine Zug- oder Druckbewegungen aufnehmen kann, die sich am fertigen Modul durch Temperaturwechselbelastungen ergeben können. In einem sich anschließenden vertikalen Teil 21 der Lasche 3 ist unten die als Rastnase wirkende Ausbeulung 15 zu erkennen und darüber die seitlichen Einkerbungen 14 und ganz oben das Loch 13 für den Stromanschluß.

Das beschriebene und in der Zeichnung dargestellte Leistungshalbleitermodul kann in nachstehenden Verfahrensschritten hergestellt werden.

Zunächst werden drei Hauptkomponenten für den Zusammenbau vorbereitet: Das Substrat 5, das Gehäuse 2 und der Deckel 4. Das Substrat 5 wird mit Leistungshalbleiterchips 6 und modulinternen Verbindungselementen 7 bestückt und mittels Weichlot verlötet. Dabei werden die Anschlußflächen 12 für die Anschlußlaschen 3 ebenfalls mit Lot vorbenetzt.

In einem getrennten Arbeitsgang kann das Kunststoffgehäuse 2 bereits mit Anschlußlaschen 3 vorbestückt werden. Danach wird das Substrat 5 mittels eines elastischen Silikonklebstoffes in das unten offene Gehäuse 2 geklebt. Anschließend werden die Laschenfüße 17 der auf dem Substrat 5 aufliegenden Anschlußlaschen 3 mit dem Substrat 5 verlötet, z.B. durch eine sogenannte Impulslötung, bei der mittels eines beheizten Stempels unter äußerem Druck die Lötverbindung hergestellt wird. In der Regel wird im nächsten Schritt eine geringe Menge einer weichelastischen Silikonmasse, z.B. eines Gels, zum Schutz der Chips 6 und zur Herstellung der Isolationsfähigkeit zwischen Leiterbahnen 11 eingefüllt. In diesem Zustand sind oder wären die Lötverbindungen der Laschen noch Zug- und Druckkräften bzw. Scherkräften ausgesetzt, die von außen auf die Anschlüsse einwirken können. Um dies zu verhindern, wird - wie in Figur 4 und 5 dargestellt ist - mittels einer speziell geformten Ultraschallsonotrode 24 der Kunststoff eines oberen Teils 25 der Führungselemente 8 in die Einkerbungen 14 der Laschen 3 hineingedrückt. Dabei kommt es zu einer festen Verankerung der Laschen 3 im Gehäuse 2. Die Sonotrode 24 wird dabei senkrecht von oben nach unten bewegt. Die dargestellte Anschrägung an der Spitze der Sonotrode 24 ist dabei mit dem Kunststoffteil 25 in Kontakt. Figur 4 zeigt den Zustand der Führungselemente 8 vor der Ultraschallschweißung und Figur 5 den verformten oberen Teil 25 nach dem Schweißvorgang.

Zur Fertigstellung des Moduls 1 wird der Deckel 4 aufgesetzt. Die Laschen 3 werden dabei durch die Schlitze 9 im Deckel 4 geführt. In die Vertiefung 10 des Deckels 4 werden Muttern eingelegt und die Laschen 3 werden anschließend darüber um 90° umgebogen, so daß die Muttern nicht mehr herausfallen können.

Wie bereits erwähnt, können Module mit Steuer- oder Hilfsanschlüssen auf ähnliche Weise hergestellt werden. In diesem Fall wird die in Figur 6 dargestellte obere Kante 23 von Kunststoffteilen im Bereich der Ausnehmungen 19 mit Hilfe einer Sonotrode verformt, so daß der Kunststoff über der Schulter 22 der eingesetzten Steueranschlußteile 20 in die Ausnehmung 19 gedrückt wird.

Die Erfindung ist nicht auf Module mit einem Keramiksubstrat als Boden beschränkt, sondern kann auch bei Modulen mit einem z.B. 3 bis 10 mm dicken Metallboden angewendet werden.

Die oben beschriebene Folge von Fertigungsschritten wird bevorzugt, weil die Fixierung der Anschlußlaschen 3 am Gehäuse 2 erst nach der Befestigung des Substrats 5 am Gehäuse 2 und nach dem Verlöten der Laschen 3 mit dem Substrat 5 erfolgt und somit Fertigungstoleranzen ohne weiteres ausgeglichen werden können. Wenn die einzelnen Montageschritte mit ausreichend kleinen Toleranzen durchgeführt werden, ist auch eine Befestigung der Anschlußlaschen 3 am Gehäuse 2 sofort nach der Bestückung des Gehäuses 2 möglich. Besonders dann sind auch alternative Befestigungsarten zum Ultraschallschweißen anwendbar, wie z.B. eine thermoplastische Verformung von Kunststoffteilen.

## Patentansprüche

1. Leistungshalbleitermodul (1) mit
- wenigstens einem Leistungshalbleiterbauelement (6),
- Anschlußelementen (3,20) für nach außen führende elektrische Anschlüsse und
- einem Kunststoffgehäuse (2), das im Inneren angeformte Führungselemente (8) aus Kunststoff aufweist, die während der Modulherstellung als Lötform für die Anschlußelemente (3,20) wirken,
dadurch gekennzeichnet, daß die Anschlußelemente (3,20) durch verformte Teile (25,28) der Führungselemente (8) mechanisch fest mit dem Kunststoffgehäuse (2) verbunden sind.

2. Leistungshalbleitermodul (1) nach Anspruch 1, dadurch gekennzeichnet, daß als Anschlußelemente Anschlußlaschen (3) mit Einkerbungen (14) eingesetzt sind, wobei in die Einkerbungen (14) durch Ultraschall-Schweißung verformte Kunststoffteile (25) gedrückt sind.

3. Leistungshalbleitermodul (1) nach einem der vorstehenden Ansprüche, dadurch gekennzeichnet, daß die Anschlußlaschen (3) eine als Rastnase wirkende Ausbeulung (15) aufweisen, mit deren Hilfe die Anschlußlaschen (3) jeweils in einen elastischen Querbalken (16) an den Führungselementen (8) einrastbar sind.

4. Leistungshalbleitermodul (1) nach einem der vorstehenden Ansprüche, dadurch gekennzeichnet, daß das Kunststoffgehäuse (2) in seiner Bodenebene eine Öffnung (26) mit einem Absatz (27) aufweist, in die ein keramisches Substrat (5) eingesetzt ist, wobei das Substrat (5) auf beiden Hauptflächen eine Metallschicht tragen kann.

5. Verfahren zur Herstellung eines Leistungshalbleitermoduls (1), gekennzeichnet durch nachstehende Schritte:
a) Bereitstellung eines Substrats (5) als Modulboden, eines Kunststoffgehäuses (2) und eines Gehäusedeckels (4);
b) Bestücken des Substrats (5), das Leiterbahnen (11) aufweist, mit Leistungshalbleiterbauelementen (6) und Verbindungselementen (7);
c) Verlöten des bestückten Substrats (5) mittels Weichlot, wobei auch Anschlußflächen (12) für Anschlußlaschen (3) mit Lot benetzt werden,
d) Bestücken des Kunststoffgehäuses (2) mit Anschlußelementen (3,20), die in Führungsschächte gesteckt werden, die durch angeformte Führungselemente (8) an den Innenwänden des Kunststoffgehäuses (2) bzw. durch Ausnehmungen (19) im Gehäuse (2) gebildet werden,
e) Verbinden des Gehäuses (2) mit dem Substrat (5) durch Verkleben;
f) Verbinden der Anschlußlaschen (3) mit dem Substrat (5) mittels Weichlöten, vorzugsweise mittels Impulslöten;
g) Herstellen einer festen mechanischen Verbindung zwischen dem Kunststoffgehäuse (2) und den Anschlußelementen (3,20) durch Ultraschall-Schweißen, wobei ein oberer Kunststoffteil (25) der Führungselemente (8) von einer Sonotrode (24) in Einkerbungen (14) der Anschlußlaschen (3) gedrückt wird bzw. ein Kunststoffteil (29) in die Ausnehmung (19) gedrückt wird und
h) Aufsetzen und Verbinden des Gehäusedeckels (4), der Schlitze (9) zur Durchführung der Anschlußelemente (3,20) aufweist.

6. Verfahren nach Anspruch 5, dadurch gekennzeichnet, daß nach dem Ultraschall-Schweißen des Verfahrensschritts g) eine kleine Menge Weichvergußmasse in das Modul gefüllt wird.

## Claims

1. Power semiconductor module (1) comprising
- at least one power semiconductor component (6),
- connecting elements (3, 20) for electrical connections which run outwards, and
- a plastic housing (2) which has plastic guide elements (8) moulded on in the interior, which guide elements (8) act as soldering jig for the connecting elements (3, 20) during the module production,
characterized in that the connecting elements (3, 20) are firmly connected mechanically to the plastic housing (2) by deformed parts (25, 28) of the guide elements (8).

2. Power semiconductor module (1) according to Claim 1, characterized in that connecting lugs (3) with notches (14) are used as connecting elements, deformed plastic parts (25) being pressed into the notches (14) by ultrasonic welding.

3. Power semiconductor module (1) according to one of the preceding claims, characterized in that the connecting lugs (3) have a bulge (15) which acts as latching projection and with whose aid the connecting lugs (3) can be latched in each case into an elastic transverse bar (16) on the guide elements (8)

4. Power semiconductor module (1) according to one of the preceding claims, characterized in that the plastic housing (2) has an opening (26) in its base plane with a shoulder (27), into which opening (26) a ceramic substrate (5) is inserted, it being possible for the substrate (5) to carry a metal layer on both principal faces.

5. Method of producing a power semiconductor module (1), characterized by the following steps:
a) provision of a substrate (5) as module base, of a plastic housing (2) and of a housing lid (4);
b) fitting of the substrate (5), which has conductor tracks (11), with power semiconductor components (6) and connecting elements (7);
c) soldering of the fitted substrate (5) by means of soft solder, connecting areas (12) for connecting lugs (3) also being wetted with solder,
d) fitting of the plastic housing (2) with connecting elements (3, 20) which are inserted into guide channels, which are formed by moulded-on guide elements (8) on the inside walls of the plastic housing (2) or by recesses (19) in the housing (2),
e) connection of the housing (2) to the substrate (5) by bonding;
f) connection of the connecting lugs (3) to the substrate (5) by means of soft soldering, preferably by means of pulse soldering;
g) production of a firm mechanical connection between the plastic housing (2) and the connecting elements (3, 20) by ultrasonic welding, an upper plastic part (25) of the guide elements (8) being pressed into notches (14) of the connecting lugs (3) by a horn (24), or a plastic part (29) being pressed into the recess (19), and
h) mounting and connection of the housing lid (4), which has slits (9) for feeding-through the connecting elements (3, 20).

6. Method according to Claim 5, characterized in that a small amount of soft encapsulation compound is poured into the module after the ultrasonic welding of method step g).

## Revendications

1. Module à semi-conducteurs de puissance (1) comportant
- au moins un composant à semi-conducteurs de puissance (6),
- des éléments de connexion (3, 20) pour des connexions électriques menant vers l'extérieur et
- un boîtier (2) en matière plastique qui présente intérieurement des éléments de guidage (8) moulés en matière plastique, qui au cours de la fabrication du module servent de forme de soudage pour les éléments de connexion (3, 20),
caractérisé par le fait que les éléments de connexion (3, 20) sont rendus solidaires mécaniquement du boîtier (2) en matière plastique par des parties (25, 28) déformées des éléments de guidage (8).

2. Module à semi-conducteurs de puissance (1) selon la revendication 1, caractérisé par le fait que l'on utilise comme éléments de connexion des pattes de connexion (3) pourvues d'encoches (14), des parties de matières plastique (25) déformées par soudage par ultrasons étant refoulées dans les encoches (14).

3. Module à semi-conducteurs de puissance (1) selon l'une des revendications précédentes, caractérisé par le fait que les pattes de connexion (3) présentent un renflement (15) qui agit comme nez d'encliquetage et au moyen duquel les pattes de connexion (3) peuvent être encliquetées chacune dans une barrette transversale (16) élastique des éléments de guidage (8).

4. Module à semi-conducteurs de puissance (1) selon l'une des revendications précédentes, caractérisé par le fait que le boîtier (2) en matière plastique présente dans le plan de son fond une ouverture (26) avec un décrochement (27) dans laquelle est logé un substrat (5) en céramique, le substrat (5) pouvant porter sur ses deux faces principales une couche métallique.

5. Procédé de fabrication d'un module à semi-conducteurs de puissance (1), caractérisé par les étapes suivantes:
a) préparation d'un substrat (5) comme fond du module, d'un boîtier (2) en matière plastique et d'un couvercle (4) de boîtier;
b) mise en place sur le substrat (5) qui comporte des pistes conductrices (11) des composants à semi-conducteurs de puissance (6) et des éléments de liaison (7);
c) soudage du substrat (5) équipé à la soudure tendre, les surfaces de connexion (12) pour les pattes de connexion (3) étant également mouillées avec la soudure.
d) mise en place dans le boîtier (2) en matière plastique d'éléments de connexion (3, 20) qui sont enfilés dans des puits de guidage formés par des éléments de guidage (8) moulés sur les parois intérieures du boîtier (2) en matière plastique ou par des évidements (19) dans le boîtier (2),
e) réalisation par collage de la liaison entre le boîtier (2) et le substrat (5);
f) réalisation de la liaison entre les pattes de connexion (3) et le substrat (5) par soudage tendre, de préférence par soudage par impulsion;
g) réalisation d'une liaison mécanique ferme entre le boîtier (2) en matière plastique et les éléments de connexion (3, 20) par soudage par ultrasons, une partie (25) supérieure en matière plastique des éléments de guidage (8) étant repoussée par une sonotrode (24) dans des encoches (14) des pattes de connexion (3) ou une partie (29) en matière plastique étant enfoncée dans l'évidement (19);
h) mise en place et réalisation de la liaison du couvercle (4) de boîtier qui comporte des fentes (9) pour le passage des éléments de connexion (3, 20).

6. Procédé selon la revendication 5, caractérisé par le fait qu'à la suite du soudage par ultrasons de l'étape g) du procédé on introduit dans le module une faible quantité de masse moulable souple.
